# EUROPÄISCHE PATENTSCHRIFT

(11) **EP 0 806 825 B1**
(45) Veröffentlichungstag und Bekanntmachung des Hinweises auf die Patenterteilung: **09.07.2003**
(21) Anmeldenummer: 97101634.0
(22) Anmeldetag: 03.02.1997
(51) Int. Cl.: H02H 3/33

(54) **DI-Schutzschalteinrichtung**
Differential current protection
Système de protection différentielle

(30) Priorität: 07.05.1996 DE 19618279
(43) Veröffentlichungstag der Anmeldung: 12.11.1997
(73) Patentinhaber: HEINRICH KOPP AG, D-63796 Kahl am Main (DE)
(72) Erfinder: Heinz, Klaus Dieter, 63450 Hanau (DE); Thiele, Stefan, Dipl.-Ing.FH, 63796 Kahl (DE)
(74) Vertreter: Reinhard - Skuhra - Weise & Partner

(56) Entgegenhaltungen:
- EP-A- 0 189 493
- FR-A- 2 643 195
- GB-A- 2 204 199

## Beschreibung

Die Erfindung betrifft eine DI-Schutzschalteinrichtung gemäß dem Oberbegriff des Patentanspruchs 1.

Eine DI-Schutzschalteinrichtung entsprechend dem Oberbegriff des Patentanspruchs 1 ist aus der GB-A-2 204 199 bekannt. Diese Schutzschalteinrichtung dient zur Erfassung eines Fehlerzustandes des Schutzleiters, nämlich der Unterbrechung des Erdleiters.

In der EP-A-0 189 493 ist ein FI-Schutzschaltgerät angegeben, welches an Anschlussstecker ausgebildet ist, die einen Summenstromwandler zu Erfassung von Fehlerströmen in einem Phasenleiter und einem Nullleiter aufweist. Hierbei dient ein Summenstromwandler zur Erkennung des Schutzleiterzustandes.

Diese Fehlerstromschutzschalteinrichtung weist ferner eine Potentialtrennstufe sowie eine parallel dazu geschaltete Schalteinrichtung auf. Diese Fehlerstromschutzschalteinrichtung stellt einen netzspannungsunabhängigen Fehlerstromschutzschalter dar, bei dem die Funktion der Erfassung, der Auswertung und der Abschaltung nicht von der Netzspannung abhängen.

Aus der FR-A-2 643 195 ist eine Fehlerstromschutzschalteinrichtung bekannt, mit einem Summenstromwandler zur Erfassung von Fehlerströmen in einem Phasenleiter und einem Nullleiter und mit einem DI-Schalter. Eine elektronische Schaltung ist mit einem Messfühler verbunden. Die elektronische Schaltung empfängt über einen Opto-Koppler ein Informationssignal vom Messfühler. Durch das vom Messfühler abgegebene Signal wird ein Differenzstrom in den Leitern hervorgerufen. Bei dieser Schaltung liefert der Messfühler 31 ein Signal an die elektronische Schaltung, wobei der Messfühler nicht zum Erkennen des Vorhandenseins einer Phasenspannung auf dem Schutzleiter vorgesehen ist. Damit erkennt diese Fehlerstromschutzschaltung nicht das Vorhandensein einer Phasenspannung auf dem Schutzleiter.

Die bisher bekannten Fehlerstromschutzschalter sind nicht in der Lage, verschiedene Fehlersituationen in Zusammenhang mit dem Schutzleiter (PE) zu erkennen. Beispielsweise ein Bruch, also ein Nichtvorhandensein des Schutzleiters (PE), ist nicht erkennbar, da bei Nichtvorhandensein des Schutzleiters (PE) über diesen auch kein Strom fließen kann. Im Falle eines Defektes eines an dem Hauptstromkreis angeschlossenen Gerätes, beispielsweise einer vom einem Handwerker gehaltenen Bohrmaschine, kann also nur über den Handwerker als alleinigem Stromableiter der Fehlerstromschutzleiter zum Freischalten gebracht werden. Im Falle des Anbohrens einer Fremdphase ist nicht sichergestellt, dass der rettende Schutzleiterpfad zur Verfügung steht.

Die Fehlerstromschutzschalter können des weiteren nicht bei falsch angeschlossenem Schutzleiter (PE) die Netzspannung auf dem Schutzleiter (PE) erkennen und zum Freischalten zu nutzen. Der Fehlerstromschutzschalter bewirkt eine Stromkreisunterbre chung in einer solchen Situation erst dann, wenn ein Strom einer bestimmten Stromstärke über das Gehäuse des angeschlos senen Gerätes und beispielsweise über den Handwerker fließt. Da dieser Strom anfangs bei voller Netzspannung fließt, ergibt sich ein sehr hoher, kritischer Anfangskörperstrom, der nur durch den Körperwiderstand begrenzt ist. Dieser Anfangskörper strom kann für den Benutzer tödlich sein.

Der Erfindung liegt daher die Aufgabe zugrunde, eine DI-Fehlerstromschutzschalteinrichtung der eingangs genannten Art so zu verbessern, dass auch Fehlerzustände des Schutzleiters (PE) erkannt werden.

Diese Aufgabe wird erfindungsgemäß durch die im Patentanspruch 1 angegebenen Merkmale gelöst.

Weitere Ausgestaltungen der Erfindung ergeben sich aus den Unteransprüchen.

Die erfindungsgemäße Fehlerstromschutzschalteinrichtung ermöglicht die Erkennung eines weiteren Fehlerzustandes, nämlich das Erkennen einer an dem Schutzleiter anliegenden Phasen- bzw. Netzspannung. Die erfindungsgemäße Fehlerstromschutzschalteinrichtung erkennt neben der Unterbrechung des Schutzleiters als einen weiteren Fehlerzustand somit auch das Vorhandensein einer Phasen- bzw. Netzspannung auf dem Schutzleiter.

Der erfindungsgemäße Fehlerstromschutzschalter erkennt Fehler zustände hinsichtlich des Schutzleiters und bewirkt eine all polige Freischaltung des Hauptstromkreises. Für das Erkennen eines spannungsführenden PE-Leiters wird erfindungsgemäß eine Potentialannäherung gegenüber Erde an einem Sensor erforder lich, was z.B. durch eine ohmsche und/oder kapazitive Impedanz erreicht wird, beispielsweise durch den Benutzer, wenn dieser eine aus leitfähigem Material bestehende ON-Taste berührt.

Mit dem erfindungsgemäßen Fehlerstromschutzschalter werden falsch verdrahtete Netze bzw. fehlende Anschlüsse ohne Einsatz einer Zusatzwicklung auf dem Wandler erkannt. Im Fehlerfall lässt sich der Schutzschalter nicht mehr einschalten und schützt somit den Benutzer zusätzlich gegenüber Fehlern des PE-Leiters.

Im folgenden wird eine bevorzugte Ausführungsform der Erfindung anhand der Zeichnungen zur Erläuterung weiterer Merkmale beschrieben.

Es zeigen:
- Fig. 1: ein Blockschaltbild eines DI-Fehlerstromschutzschalt ers gemäß der Erfindung;
- Fig. 2: eine Detailansicht des in Fig. 1 gezeigten DI-Fehler stromschutzschalters.

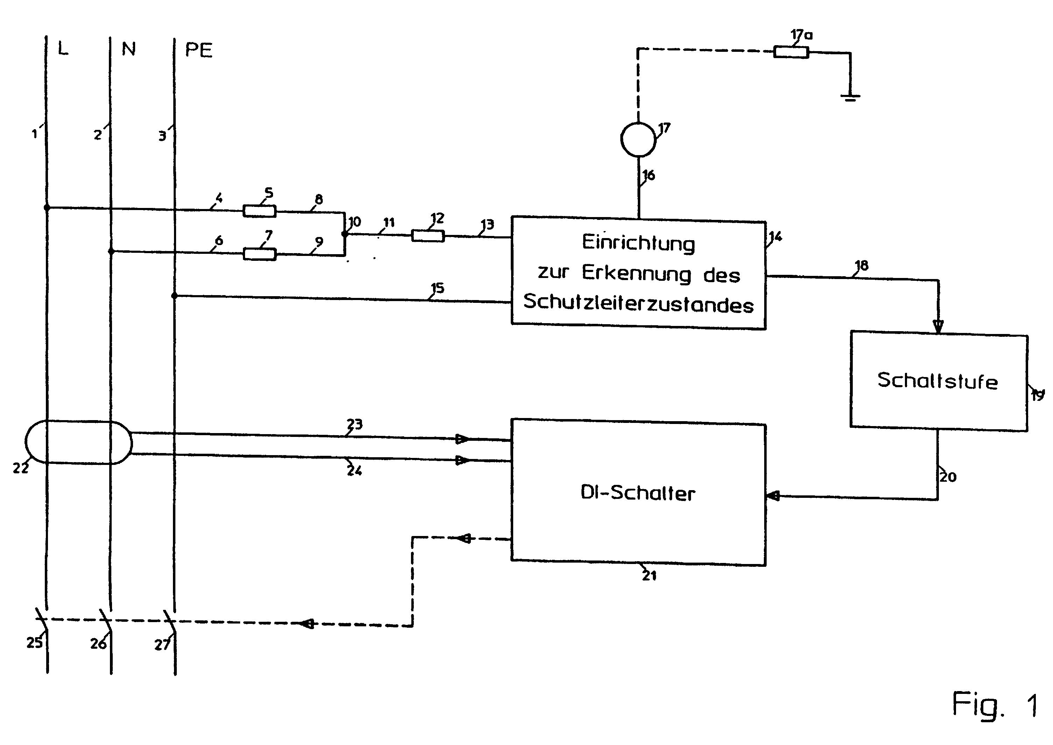

Das Blockschaltbild in Fig. 1 zeigt eine bevorzugte Ausführungsform eines Fehlerstromschutzschalters gemäß der Erfindung.

In Figur 1 ist der Phasenleiter mit 1, der Nulleiter mit 2 und der Schutzleiter mit 3 bezeichnet.

Der L-Phasenleiter 1 ist über eine Leitung 4 an eine Schutzimpedanz 5, und der N-Nulleiter 2 ist über eine Leitung 6 an eine Schutzimpedanz 7 angeschlossen. Die Schutzimpedanzen 5, 7 sind ausgangsseitig über Leiter 8, 9 an einem Knotenpunkt 10 zusammengeschaltet. Der Punkt 10 ist über eine Leitung 11 an eine weitere Schutzimpedanz 12 angeschlossen, welche ausgangsseitig über einen Leiter 13 mit einer Einrichtung 14 zur Erkennung des Schutzleiterzustandes verbunden ist. Die Schutzimpedanzen 5, 7 und 12 dienen der Strombegrenzung. Die Einrichtung 14 ist ferner über eine Leitung 15 an den Schutzleiter 3 und über eine Leitung 16 an einen Sensor 17 angeschlossen. Bei dem Sensor 17 handelt es sich um eine aus einem leitfähigen Material hergestellte Taste, welche durch eine Bedienperson berührt werden muß. Der Sensor 17 befindet sich beispielsweise am Gehäuse des angeschlossenen Gerätes.

Der Ausgang der Einrichtung 14 ist über einen Leiter 18 mit einer Schaltstufe 19 verbunden, welche über eine Leitung 20 einen DI-Fehlerstromschutzschalter 21 schaltet. Der DI-Fehlerstromschutzschalter 21 ist an einen Summenstromwandler 22 angeschlossen, dessen Primärwicklung durch den Phasenleiter 1 und den Nulleiter 2 gebildet wird. Der Summenstromwandler 22 weist ferner eine Sekundärwicklung auf, die induzierte Spannungen über Leitungen 23, 24 zu einer in dem DI-Schalter 21 enthaltenen Auswerteelektronik führt. Der DI-Schalter 21 ist mechanisch mit Schaltkontakten 25, 26, 27 gekoppelt, welche in die Leitungen 1, 2, 3 geschaltet sind. Die gesamte, in Figur 1 gezeigte Anordnung bildet die DI-Schutzschalteinrichtung.

Im folgenden wird die Funktionsweise des in Fig. 1 dargestellten erfindungsgemäßen Fehlerstromschutzschalters erläutert.

Je nach Phasenlage liegt von der Leitung 4 über die Schutzimpedanz 5 und die Leitung 8 oder über von der Leitung 6 über die Schutzimpedanz 7 und die Leitung 9 ein Stromfluß zu dem Sternpunkt 10 und von dem Sternpunkt 10 über den Leiter 11, die Schutzimpedanz 12, den Leiter 13, die Einrichtung 14 und die Leitung 15 zum Schutzleiter 3 vor. Im Normalfall, d.h. wenn der Phasenleiter 1, der Neutralleiter 2 und der Schutzleiter 3 korrekt angeschlossen sind, fließt dieser Strom durch die Einrichtung 14 über die Leitung 15 zu dem Schutzleiter 3 ab.

Fehlt jedoch dieser Strom, beispielsweise weil der Schutzleiter 3 nicht angeschlossen oder unterbrochen ist, erkennt die Einrichtung 14 diesen Fehlerzustand aufgrund des nicht über den Leiter 15 zum Schutzleiter 3 abfließenden Stromes und schaltet über eine potentialmäßig getrennte Schaltstufe 19 den DI-Schutzschalter 21, welcher die Schaltkontakte 25, 26, 27 öffnet und somit die Leiter 1, 2, 3 allpolig unterbricht.

Die Einrichtung 14 kann darüber hinaus einen weiteren Fehlerzustand nämlich das Vorhandensein einer Phase bzw. Netzspannung auf dem Schutzleiter 3, erkennen. Dazu dient die aus einem leitfähigen Material hergestellte Sensorfläche 17. Der Benutzer berührt beim Umgang mit dem Gerät, mit welchem der erfindungsgemäße Fehlerstromschutzschalter verbunden ist, die Sensorfläche 17, wodurch über die Impedanz 17 a des Benutzers am Sensor 17 eine Potentialannäherung gegen Erde erfolgt. Liegt an dem Schutzleiter 3 Phase bzw. Netzspannung an, entsteht zu der Sensorfläche 17, die durch die Berührung des Benutzers ungefähr auf Erdpotential liegt, eine Spannungsdifferenz, die durch die Einrichtung 14 als Fehlerzustand erkannt wird. Die Einrichtung 14 schaltet bei Erkennen dieses Fehlerzustandes über die Schaltstufe 19 den DI-Schalter 21, welcher die Schaltkontakte 25, 26, 27 offnet.

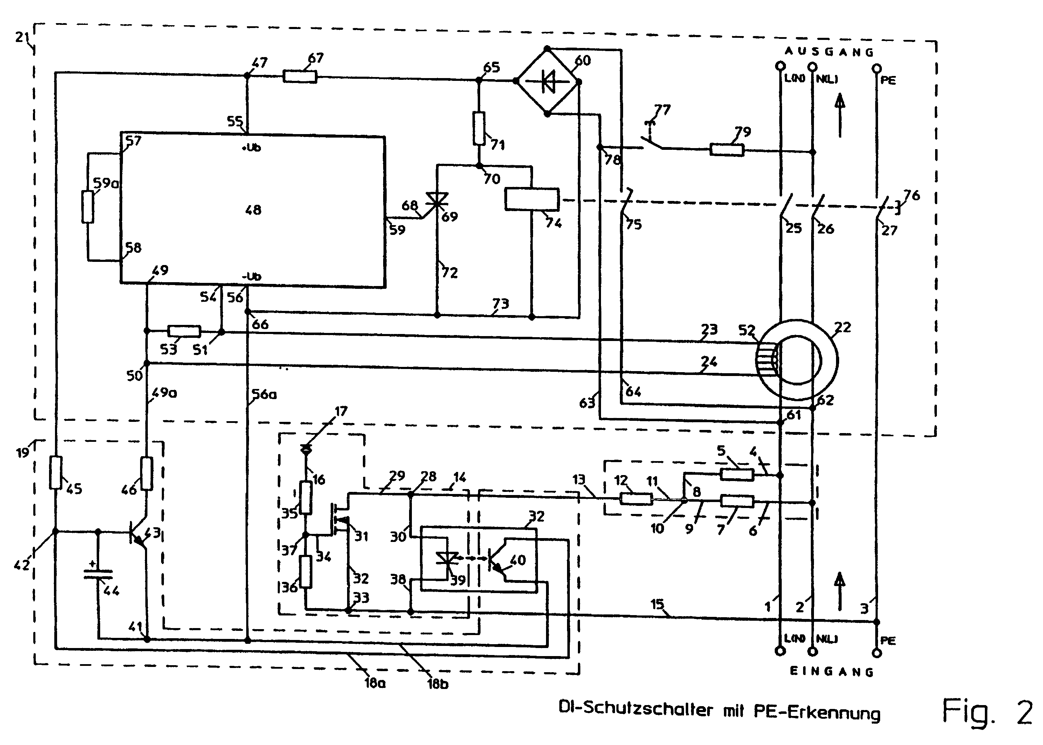

Fig. 2 zeigt eine Detailansicht des in Fig. 1 gezeigten bevorzugten DI-Fehlstromschutzschalteinrichtung mit Schutzleiterzustandserkennung gemäß der Erfindung. Dabei bezeichnen gleiche Bezugsnummern identische Bauelemente.

Zunächst wird der genaue Aufbau der in Fig. 2 gezeigten erfindungsgemäßen Fehlerstromschutzschalteinrichtung mit Schutzleiterzustandserkennung beschrieben.

Die Schutzimpedanzen 5, 7, 12 sind über die Leitung 13 mit der Einrichtung 14 zur Erkennung des Zustandes des PE-Schutzleiters 3 verbunden. Die Leitung 13 verzweigt sich in der Einrichtung 14 an einem Verzweigungspunkt 28 in zwei Leitungsabschnitte 29, 30, wobei der erste Leitungsabschnitt 29 mit einem Halbleiterschalter 31 und der zweite Leitungsabschnitt 30 mit einer Potentialtrennstufe 32 verbunden ist. Der Halbleiterschalter 31 ist vorzugsweise ein MOSFET, beispielsweise ein selbstsperrender n-Kanal MOSFET, wie er in Fig. 2 dargestellt ist. Die Leitung 29 ist an den DRAIN-Anschluß des MOSFET 31 angeschlossen. SOURCE und Masse des MOSFET 31 sind zusammengeschaltet und werden über eine Leitung 32 mit dem Knotenpunkt 33 mit der Leitung 15 verbunden, welche zu dem Schutzleiter 3 führt. Das Gate des Halbleiterschalters 31 ist über eine Leitung 34 an einen zwischen einem Schutzwiderstand 35 und einem Arbeitswiderstand 36 liegenden Knotenpunkt 37 angeschlossen. Der Schutz- bzw. Ableitwiderstand 35 ist über die Leitung 16 mit dem mit Sensor 17 verbunden.

Der Arbeitswiderstand 36 ist zwischen die Knotenpunkte 33 und 37 geschaltet. Die Potentialtrennstufe 32 befindet sich in der Einrichtung 14. Die Potentialtrennstufe ist eingangsseitig über die Leitungen 30, 38 zwischen dem Verzweigungspunkt 28 und die zum PE-Schutzleiter 3 führende Leitung 15 geschaltet. Die in Fig. 2 gezeigte Potentialtrennstufe 32 besteht vorzugweise aus einem Optokoppler. Die Potentialtrennung zwischen der Einrichtung 14 und der nachgeschalteten Schaltstufe 19 kann jedoch auch über beliebige andere potentialtrennende Bauteile erfolgen, wie beispielsweise Triac-Koppler, Opto-Feldeffekttransistoren, Piezokoppler, Übertrager oder Relais. Die Potentialtrennstufe 32 in Form eines Optokoppler enthält eingangsseitig eine Leuchtdiode 39, welche zwischen den Leitungen 30 und 38 liegt. Ausgangsseitig weist die Potentialtrennstufe 32 einen lichtempfindlichen Transistor 40 auf, der bei Empfang von Licht, welches von der Leuchtdiode 39 ausgestrahlt wird, leitend wird. Der Emitter des Transistors 40 ist über einen Leiter 18b mit dem Knotenpunkt 41, und der Kollektor des Transistors 40 ist über einen Leiter 18a mit dem Knotenpunkt 42 der Schaltstufe 19 verbunden. Die Schaltstufe 19 enthält einen Halbleiterschalter 43, beispielsweise einen npn-Transistor, wie in Fig. 2 gezeigt ist. Die Basis des Transistors 43 ist mit dem Knotenpunkt 42 und der Emitter mit dem Knotenpunkt 41 verbunden. Ein Glättungskondensator 44 ist parallel zu dem Basis-Emitter-Übergang des Transistors 43 zwischen die Knotenpunkte 41 und 42 geschaltet. Die Schaltstufe 19 weist ferner zwei Strombegrenzungswiderstände 45, 46 für den Halbleiterschalter 43 auf. Der erste Strombegrenzungswiderstand 45 ist zwischen der Basis 42 des Halbleiterschalters 43 und einem Knotenpunkt 47 angeordnet, welcher auf dem Potential einer positiven Betriebsspannung (+U_{b}) einer integrierten Schaltung 48 liegt. Der zweite Strombegrenzungswiderstand 46 der Schaltstufe 19 ist zwischen den Kollektor des Halbleiterschalters 43 und über eine Leitung 49a an einen Knotenpunkt 50 geschaltet. Eine Sekundärwicklung 52 des Summenstromwandlers 22 liegt über die Leitung 23 am Knotenpunkt 51 und über die Leitung 24 am Knotenpunkt 50 an. Ein Wandlerabschlußwiderstand 53 ist zwischen die beiden Knotenpunkte 50, 51 parallel zu der Sekundärwinklung 52 geschaltet. Der Knotenpunkt 50 ist mit einem Anschluß 49, und der Knotenpunkt 51 mit einem Anschlußpunkt 54 der integrierten Schaltung 48 verbunden. Die Versorgungsspannung erhält die integrierte Schaltung 48 über zwei Betriebsspannungsanschlüsse 55, 56, wobei der erste Anschluß 55 auf einem positiven Betriebsspannungspotential (+U_{b}) und der zweite Anschluß 56 auf einem negativen Betriebsspannungspotential (-U) liegt. Die beiden Betriebsspannungsanschlüsse 55, 56 der integrierten Schaltung 48 sind IC-intern über eine aus mehreren in Reihe geschalteten Z-Dioden bestehende Diodenkette, welche der Stabilisierung dient, verbunden. Der Anschlußpunkt 49 ist dabei mit einem IC-internen Knotenpunkt verbunden, welcher in der Mitte der Z-Diodenkette liegt. Somit liegt der Anschlußpunkt 49 auf halber Betriebsspannung und weist ein Bezugspotential auf. Die Spannungsversorgung der integrierten Schaltung 48 über die Anschlüsse 55, 56 wird durch eine Gleichrichterschaltung 60 gewährleistet, welche die Wechselspannung auf dem Phasenleiter 1 und dem Nulleiter 2 an den Punkten 61, 62 über die Leiter 63, 64 abgreift, gleichrichtet und eine Gleichspannung zwischen den Knotenpunkten 65 und 66 liefert. Der Knotenpunkt 65 ist über einen Strombegrenzungswiderstand 67 mit dem Knotenpunkt 47 verbunden, welcher das IC 48 am Anschluß 55 mit der positiven Betriebsspannung (+U_{b}) versorgt. Der Knotenpunkt 66 versorgt das IC 48 über den Anschluß 56 mit der negativen Betriebsspannung (-U_{b}). Die integrierte Schaltung 48 weist ferner zwei weitere Anschlüsse 57, 58 auf, zwischen welchen ein einstellbarer Widerstand 59 a geschaltet ist. Durch den Einstellwiderstand 59 a ist die Empfindlichkeit der integrierten Schaltung 48 und somit der Auslösewert des DI-Schalters 21 einstellbar.

Die integrierte Schaltung 48 besitzt einen Ausgangsanschluß 59 zur Abgabe von Steuerimpulsen, welche über eine Steuerleitung 68 an einen Halbleiterschalter 69, vorzugsweise einen Thyristor, angeschlossen ist. Die vom Ausgangsanschluß 59 des IC 48 ausgehende Steuerleitung 68 steuert das Gate des Thyristors 69. Die Anode des in Fig. 2 gezeigten Thyristors 69 ist mit einem Knotenpunkt 70 verbunden, welcher über einen Strombegrenzungswiderstand 71 an dem Knotenpunkt 65 auf positivem Gleichspannungspotential liegt. Die Kathode des Thyristors 69 ist über eine Leitung 72 an eine Verbindungsleitung 73 zwischen der Gleichrichterschaltung 60 und dem Knotenpunkt 66 angeschlossen. Parallel zu dem Thyristor 69 ist ein Ruhestromauslöserelais 74 zwischen dem Knotenpunkt 70 und der Leitung 73 geschaltet. Das Ruhestromauslöserelais 74 ist mechanisch mit den Schaltkontakten 25, 26, 27 der Leiter 1, 2, 3 sowie mit einem Schalter 75, durch welchen der Leiter 64 unterbrechbar ist, gekoppelt. Die Kontakte 25, 26, 27 sowie der Schalter 75 sind über eine Einschalttaste 76 bzw. einen Schaltknebel zum Aktivieren des Schutzschalters betätigbar. Der DI-Schalter 21 weist ferner eine Prüftaste 77 auf, welche einerseits über den Knotenpunkt 78 an die Betriebsstromzuleitung 63 angeschlossen und andererseits in Reihe mit einem Widerstand 79 zur Einstellung eines Prüfstromes an den Nulleiter 2 geschaltet ist.

Nachfolgend wird die Funktionsweise des erfindungsgemäßen Fehlerstromschutzschalters mit Schutzleiterzustandserkennung anhand der in Fig. 1 und 2 gezeigten bevorzugten Ausführungsform erläutert.

Der Fehlerstromschutzschalter arbeitet im Normalbetrieb, wenn der Schutzleiter 3 korrekt angeschlossen ist, keine Phase auf dem Schutzleiter 3 auftritt und kein Fehlerstrom auf der Ausgangs- bzw. Verbraucherseite fließt.

Durch Drücken der Taste bzw. des Schaltknebels 76 werden die Schaltkontakte 25, 26, 27 geschlossen und die Eingangsspannung wird über die Leiter 1, 2, 3 zum Ausgang bzw. zur Verbraucherseite durchgeschaltet. Das Drücken der Taste 76 bewirkt gleichzeitig ein Schließen des Schalters 75, wodurch über die Betriebsstromzuleitung 64 der Gleichrichterschaltung 60 ein Betriebsstrom zugeführt wird. Die Gleichrichterschaltung 60 liefert am Knotenpunkt 65 und nach entsprechendem Spannungsabfall am Strombegrenzungswiderstand 71 eine positive Spannung am Knotenpunkt 70. Dadurch zieht das Ruhestromauslöserelais 74 an und hält die Kontakte 25, 26, 27 sowie 75 nach dem Loslassen der Taste 76 geschlossen.

Bei Auftreten eines Fehlerstromes auf dem Phasenleiter 1 und dem Nulleiter 2 wird in der Sekundärwicklung 52 des Summenstromwandlers 22, dessen Primärwicklungen durch die Leiter 1 und 2 gebildet werden, ein Strom induziert. Der induzierte Strom wird über die Leitungen 23, 24 geleitet und bewirkt einen Spannungsabfall an dem Abschlußwiderstand 53 des Summenstromwandlers 22. Durch den Spannungsabfall an dem Widerstand 53 erhält die integrierte Schaltung 48 über die Anschlüsse 49 und 54 ein Signal, welches der Höhe des Fehlerstromes entspricht. Durch den Einstellwiderstand 59 a ist die Empfindlichkeit der integrierten Schaltung 48 und somit die Höhe des Auslösewertes einstellbar. Überschreitet die Spannung zwischen den Anschlüssen 49 und 54 bzw. die Spannung am Abschlußwiderstand 53 den eingestellten Auslösewert, gibt die integrierte Schaltung 48 an ihrem Ausgang 59 über die Steuerleitung 68 ein Steuersignal an das Gate des Thyristors 69 ab und zündet diesen. Der gezündete Thyristor 69 schließt das parallel zu ihm geschaltete Ruhestromauslöserelais 74 kurz, das Relais 74 fällt ab und öffnet die Schaltkontakte 25, 26, 27 sowie den Schalter 75. Durch Öffnung der Schaltkontakte 25, 26, 27 werden die Leiter 1, 2, 3 unterbrochen und somit die Ausgangsseite des Fehlerstromschutzschalters vom Eingang getrennt. Gleichzeitig wird durch Öffnen des Schalters 75 die Spannungsversorgung für den Fehlerstromschutzschalter unterbrochen.

Der erfindungsgemäße Fehlerstromschutzschalter weist darüber hinaus zusätzliche Schutzfunktionen auf, da er neben dem Auftreten eines Fehlerstroms auch weitere Fehlerzustände erfaßt. Der Fehlerstromschutzschalter erkennt durch die Einrichtung 14 als weitere Fehlerzustände einen nicht angeschlossenen bzw. unterbrochenen PE-Schutzleiter 3 sowie das Vorhandensein einer Spannung bzw. Phase auf dem PE-Schutzleiter 3.

Im Normalbetrieb fließt bei korrektem Anschluß des Schutzleiters 3, wie bereits im Zusammenhang mit Fig. 1 erläutert, je nach Phasenlage über die Schutzimpedanzen 5, 12 oder 7, 12 ein Strom über die Leitung 13 durch die Leitung 30, die Leuchtdiode 39 der Potentialtrennstufe 32 sowie die Leitungen 38 und 15 zu dem Schutzleiter 3 ab. Durch das Leuchten der Diode 39 wird der lichtempfindliche Transistor 40 der Potentialtrennstufe 32 durchgeschaltet und die Basis-Emitterstrecke des Transistors 43 in der Schaltstufe 19 kurzgeschlossen. Durch das Kurzschließen der Knotenpunkte 41 und 42 in der Schaltstufe 19 wird eine Aufladung des Glättungskondensators 44 über den an einem positiven Potential liegenden Strombegrenzungswiderstand 45 verhindert, und der Transistor 43 sperrt. Der gesperrte Transistor 43 verhindert einen Kurzschluß zwischen dem Anschlußpunkt 49 und dem Anschluß 56, welcher eine negative Betriebsspannung (-U_{b}) aufweist, über die Leitung 49 a, den Widerstand 46 sowie über die Leitung 56a. Auf diese Weise bleibt die Symmetrie der Betriebsspannungen eines IC-internen Fensterkomparators erhalten, und das IC 48 gibt keinen Steuerimpuls über die Steuerleitung 68 an den Thyristor 69 ab, der dadurch gesperrt bleibt und das Relais 74 nicht kurzschließt.

Durch die beschriebene Wirkungskette bleiben die Schaltkontakte 25, 26, 27 sowie 75 geschlossen, solange über die Potentialtrennstufe 32 in der Einrichtung 14 eingangsseitig ein Strom zu dem Schutzleiter 3 abfließt und kein Fehlerstrom durch den Summenstromwandler 22 erfaßt wird.

Ist der Schutzleiter 3 jedoch nicht angeschlossen bzw. unterbrochen, wird der über die Leitung 13 zugeführte Strom nicht zur Leitung 15 abgeleitet. In einem solchen Fehlerzustand fließt kein Strom über die Leuchtdiode 39, welche folglich erlischt und somit den lichtempfindlichen Transistor 40 sperrt. Dadurch wird der Kurzschluß zwischen den Knotenpunkten 41 und 42 in der Schaltstufe 19 aufgehoben und der Kondensator 44 lädt sich über den Widerstand 45, der am Knotenpunkt 47 auf positivem Betriebsspannungspotential liegt, auf. Die Basis-Emitter-Spannung des Halbleiterschalters 43 steigt bis zu einem bestimmten Spannungswert an und schaltet dann den Transistor 43 durch. Dies bewirkt einen Kurzschluß des Bezugspunktes 49 und des Anschlusses 56 der integrierten Schaltung 48 über die Leitungen 49a, den Widerstand 46, den Transistor 43 sowie die Leitung 56a. Dadurch wird eine Unsymmetrie der Versorgungsspannungen an dem IC-internen Fensterkomparator hervorgerufen, der einen Steuerimpuls am Ausgang 59 über die Steuerleitung 68 an das Gate des Thyristors 69 abgibt. Durch den Steuerimpuls zündet der Thyristor 69 und schaltet durch. Der parallel zum Thyristor 69 geschaltete Ruhestromauslöser 74 wird kurzgeschlossen und fällt ab, wodurch die Schaltkontakte 25, 26, 27 sowie 75 geöffnet werden.

Ein nicht angeschlossener bzw. unterbrochener Schutzleiter 3 führt somit unmittelbar eine Auslösung der Schaltkontakte 25, 26, 27 herbei und trennt sofort den Spannungseingang zuverlässig von dem verbraucherseitigen Ausgang. Der erfindungsgemäße Fehlerstromschutzschalter mit Schutzleiterzustandserkennung läßt sich bei nicht angeschlossenem Schutzleiter 3 mittels der Taste 76 nicht einschalten.

Bei einer weiteren, nicht dargestellten Ausführungsform wird die Bedienperson durch eine Anzeigeeinrichtung darüber informiert, daß der Schutzleiter 3 nicht angeschlossen bzw. unterbrochen ist.

Die Einrichtung 14 erkennt neben einem unterbrochenen bzw. nicht angeschlossenen Schutzleiter 3 als weiteren Fehlerzustand das Anliegen einer Spannung bzw. einer Phase auf dem Schutzleiter 3.

Ist der Fehlerstromschutzschalter zwar korrekt angeschlossen, führt aber der Schutzleiter 3 Netzspannung, z.B. PEN vertauscht, fließt je nach Phasenlage ein durch die Leitung 15 abgeleiteter Strom über die Leitung 38, die Leuchtdiode 39 und die Leitung 30 oder über die Leitung 32, den Halbleiterschalter 31 und die Leitung 29 zu der Leitung 13 und von dort über die Schutzimpedanzen 12, 7 oder 5 zu dem Nulleiter 2 ab. Der in Fig. 2 gezeigte n-Kanal MOSFET 31 begrenzt durch seine interne Substratdiode die negativen Halbwellen, während die positiven Halbwellen über die Leuchtdiode 39 den lichtempfindlichen Transistor 40 der Potentialtrennstufe 32 durchsteuern. Ein durchgesteuerter Transistor 40 entspricht zunächst dem Normalbetrieb, verhindert ein Durchschalten des in der Schaltstufe 19 enthaltenen Halbleiterschalters 43 und somit ein Auslösen des DI-Schalters 21. Erfolgt jedoch eine Berührung der metallischen Sensorfläche bzw. ON-Taste 17 durch einen Benutzer, wird das Gate des Halbleiterschalters 31 über die Leitung 34, den Ableitwiderstand 35, die Leitung 16, die Sensorfläche 17 sowie über die in Figur 2 nicht dargestellte Impedanz 17 a des Benutzers gegen Erdpotential gezogen. Dadurch wird der Halbleiterschalter 31 leitend und schließt die Leuchtdiode 39 kurz. Dies bewirkt eine Sperrung des Transistors 40 und ein Aufladen des Glättungskondensators 44 in der Schaltstufe 19 über den Widerstand 45. Der Transistor 43 in der Schaltstufe 19 schaltet durch, und eine Unsymmetrie der Versorgungsspannung an dem IC-internen Fensterkomparator wird hervorgerufen. Das IC 48 gibt einen Steuerimpuls über die Steuerleitung 68 an das Gate des Thyristors 69 ab, welcher zündet und das Ruhestromauslöserelais 74 kurzschließt. Das kurzgeschlossene Relais fällt ab und öffnet die Schaltkontakte 25, 26, 27 sowie den Schalter 75.

Liegt also an dem Schutzleiter 3 eine Netzspannung an, wird dieser Fehlerzustand bei Berührung der Sensorfläche 17 durch den Benutzer von der Einrichtung 14 erkannt und führt zur sofortigen Trennung des verbraucherseitigen Ausgangs vom Eingang des Fehlerstromschutzschalters. Der erfindungsgemäße Fehlerstromschutzschalter löst bei einem spannungsführenden Schutzleiter 3 nicht erst dann aus, wenn bereits ein Fehlerstrom über den Benutzer bzw. Handwerker zur Erde geflossen ist, sondern läßt sich in diesem Falle gar nicht erst einschalten.

Ein zusätzlicher Vorteil besteht darin, daß kein Abschalten beim Anbohren einer Fremdphase erfolgt, d.h. Schutz über geschalteten PE bleibt.

Durch den vorstehend in Zusammenhang mit den Fig. 1 und 2 beschriebenen Fehlerstromschutzschalter werden falsch verdrahtete Netze bzw. fehlende Anschlüsse ohne Zusatzwicklungen auf dem Summenstromwandler 22 erkannt. Im Fehlerfall läßt sich der erfindungsgemäße Fehlerstromschutzschalter nicht mehr einschalten und schützt den Benutzer zusätzlich gegenüber Fehlern beim Anschluß des Schutzleiters 3, gegen Unterbrechungen des Schutzleiters 3 sowie gegen Auftreten von Netzspannung auf dem Schutzleiter 3. Diese Fehler wurden bei den bisher bekannten Fehlerstromschutzschaltern nicht erkannt und berücksichtigt. Trotz der erweiterten Schutzfunktionen konnten zusätzliche Hilfswicklungen am Summenstromwandler 22 entfallen, da die elektronische Einrichtung 14 zur Erkennung des Schutzleiterzustandes direkt über die Schaltstufe 19 auf das im DI-Schalter 21 befindliche IC 48 wirkt und nicht über Hilfswicklungen einen Fehlerstrom fließen läßt.

Bei einer weiteren nicht gezeigten Ausführungsform wird durch eine Auswerteelektronik beim Auslösen des Fehlerstromschutzschalters, wenn der Fehlerstromschutzschalter sich nicht einschalten läßt, der Benutzer über die Ursache der Auslösung bzw. über den Grund, warum der Fehlerstromschutzschalter sich nicht einschalten läßt, informiert. Dabei wird dem Benutzer über eine an die Auswerteelektronik angeschlossene Anzeigeeinrichtung angezeigt, ob der DI-Schalter 21 wegen eines aufgetretenen Fehlerstroms, eines unterbrochenen bzw. nicht angeschlossenen PE-Schutzleiters 3 oder wegen einer auf dem Schutzleiter 3 aufgetretenen Netzspannung ausgelöst hat bzw. sich nicht einschalten läßt. Diese Anzeige erleichtert die Behebung der Fehlerursache durch den Benutzer erheblich.

## Patentansprüche

1. DI-Fehlerstromschutzschalteinrichtung, mit:
einem Summenstromwandler (22) zur Erfassung von Fehlerströmen in einem Phasenleiter (1) und einem Nullleiter (2);
einer Erkennungseinrichtung (14) zur Erkennung von Fehlerzuständen eines Schutzleiters (3),
wobei die Erkennungseinrichtung (14) eingangsseitig mit dem Phasenleiter (1), dem Nullleiter (2) und dem Schutzleiter (3) und ausgangsseitig mit einer Schaltstufe (19) zum Steuern eines DI- Schutzschalters (21) verbunden ist;
**dadurch gekennzeichnet,**
**dass** der DI-Schutzschalter (21) Schaltkontakte (25, 26, 27), die in dem Phasenleiter (1), dem Nullleiter (2) und dem Schutzleiter (3) vorgesehen sind, schaltet,
**dass** der DI-Schutzschalter (21) an den Summenstromwandler (22) angeschlossen ist,
wobei die Erkennungseinrichtung (14) als einen ersten Fehlerzustand erkennt, dass der Schutzleiter (3) nicht angeschlossen oder unterbrochen ist, und als einen zweiten Fehlerzustand das Vorhandensein einer Phasenspannung auf dem Schutzleiter (3) aufgrund einer Spannungsdifferenz zwischen dem Schutzleiter (3) und einem durch einen Benutzer berührten Sensor (17) erkennt, wobei der Sensor (17) eine Sensorfläche aus leitfähigem Material aufweist, die bei Berührung durch den Benutzer auf Erdpotential gezogen wird.

2. Fehlerstromschutzschalteinrichtung nach Anspruch 1,
**dadurch gekennzeichnet, dass**
zwischen dem Phasenleiter (1) und dem Nullleiter (2) einerseits und der Erkennungseinrichtung (14) zur Erkennung von Fehlerzuständen des Schutzleiters andererseits Schutzimpedanzen (5, 7, 12) geschaltet sind.

3. Fehlerstromschutzschalteinrichtung nach Anspruch 2,
**dadurch gekennzeichnet, dass**
die Erkennungseinrichtung (14) über eine Leitung (15) mit dem Schutzleiter (3) verbunden ist.

4. Fehlerstromschutzschalteinrichtung nach einem der vorangehenden Ansprüche,
**dadurch gekennzeichnet, dass**
die Erkennungseinrichtung (14) eine Potentialtrennstufe (32) sowie eine parallel dazu geschaltete Schalteinrichtung (31) aufweist.

5. Fehlerstromschutzschalteinrichtung nach einem der vorangehenden Ansprüche,
**dadurch gekennzeichnet, dass**
unabhängig vom Anschluss des Schutzgerätes über die Widerstände (5, 7, 12), die Erkennungseinrichtung (14) und den Sensor (17) ein Bezugspotential erzeugt wird.

6. Fehlerstromschutzschalteinrichtung nach einem der vorangehenden Ansprüche,
**dadurch gekennzeichnet, dass**
die Potentialtrennstufe (32) durch einen Optokoppler, einen Triac-Koppler, einen Opto-Feldeffekttransistor, einen Piezokoppler oder ein Relais gebildet ist.

7. Fehlerstromschutzschalteinrichtung nach einem der vorangehenden Ansprüche,
**dadurch gekennzeichnet, dass**
die Schalteinrichtung (31) ein Halbleiterschaltelement ist.

8. Fehlerstromschutzschalteinrichtung nach einem der vorangehenden Ansprüche,
**dadurch gekennzeichnet, dass**
der Sensor (17) über einen Schutzwiderstand (35) an eine Steuerelektrode des Halbleiterschaltelementes (31) angeschlossen ist.

9. Fehlerstromschutzschalteinrichtung nach einem der vorangehenden Ansprüche,
**dadurch gekennzeichnet, dass**
die Potentialtrennstufe (32) ausgangsseitig mit der Schaltstufe (19) des DI-Schutzschalters (21) verbunden ist.

10. Fehlerstromschutzschalteinrichtung nach einem der vorangehenden Ansprüche,
**dadurch gekennzeichnet, dass**
die Schaltstufe (19) durch ein Halbleiterschaltelement (43) gebildet wird.

11. Fehlerstromschutzschalteinrichtung nach einem der vorangehenden Ansprüche,
**dadurch gekennzeichnet, dass**
parallel zu der Basis und zu dem Emitter des Halbleiterschaltelementes (43) der Schaltstufe (19) ein Glättungskondensator (44) geschaltet ist.

12. Fehlerstromschutzschalteinrichtung nach einem der vorangehenden Ansprüche,
**dadurch gekennzeichnet, dass**
an die Erkennungseinrichtung (14) eine Anzeigevorrichtung zum Anzeigen der Art des Fehlerzustandes angeschlossen ist.

## Claims

1. DI fault current leakage guard switching device comprising:
a totalizing current transformer (22) for detecting fault currents in phase conductor (1) and a neutral conductor (2);
a detecting means (14) for detecting fault conditions of a protective earth conductor line (3),
said detecting means being connected with its input to said phase conductor (1), neutral conductor (2) and protective earth conductor (3) and with its output being connected to a switching stage (19) for controlling a DI-guard-switch (21) **characterized in that** said DI-guard-switch (21) is switching switching contacts (25, 26, 27) which are provided in said phase conductor (1), said neutral conductor (2) and earth conductor line (3),
that said DI-guard-switch (21) is connected with said totalizing current transformer (22), wherein said detecting means (14) detects as a first fault condition that the protective earth conductor line (3) is not connected or disrupted and as a second fault condition the presence of a phase voltage at said protective earth conductor line (3) as a result of a voltage difference between the protective earth conductor line (3) and a sensor (17) which is touched by a user,
wherein said sensor (17) comprises a sensor surface of conducting material which is drawn to earth potential in case of being touched by said user.

2. Fault current leakage guard switching device according to claim 1, **characterized in that** protective impedances (5, 7, 12) are connected between said phase conductor (1) and said neutral conductor (2) on the one hand and said detecting means (14) for detecting fault conditions of the protective earth conductor line on the other hand.

3. Fault current leakage guard switching device according to claim 2, **characterized in that** the detecting means (14) is connected via a line (15) with said protective earth conductor line (3).

4. Fault current leakage guard switching device according to at least one of the proceeding claims, **characterized in that** said detecting means (14) comprises a potential-isolating stage (32) as well as a switching means (31) connected in parallel.

5. Fault current leakage guard switching device according to at least one of the proceeding claims, **characterized in that** a reference-potential is generated via said resistors (5, 7, 12), said detecting means (14) and said sensor (17) independent on the connection of said guard switch.

6. Fault current leakage guard switching device according to at least one of the proceeding claims, **characterized in that** said potential-isolating-stage (32) is formed through an opto coupler, a triac coupler, an opto fieldeffect transistor, a piezo coupler or a relay.

7. Fault current leakage guard switching device according to at least one of the proceeding claims, **characterized in that** said switching device (31) is a semiconductor element.

8. Fault current leakage guard switching device according to at least one of the proceeding claims, **characterized in that** the sensor (17) is connected with a control electrode of said semiconductor element (31) via a protective resistor (35).

9. Fault current leakage guard switching device according to at least one of the proceeding claims, **characterized in that** said potential isolating stage (32) is connected with its output to said switching stage (19) of said DI-protective switch (21).

10. Fault current leakage guard switching device according to at least one of the proceeding claims, **characterized in that** said switching stage (19) is formed by e semiconductor element (43)

11. Fault current leakage guard switching device according to at least one of the proceeding claims, **characterized in that** a smoothing capacitor (44) is connected parallel to the basis and emitter of the semiconductor switching element (43) of the switching stage (19).

12. Fault current leakage guard switching device according to at least one of the proceeding claims, **characterized in that** a display device for displaying the kind of the fault condition is connected with said detecting device (14).

## Revendications

1. Dispositif différentiel de protection contre les courants de défaut, avec :
un transformateur d'intensité de totalisation (22) pour la détection des courants de défaut dans un conducteur de phase (1) et un conducteur de neutre (2);
un dispositif d'identification (14) pour l'identification des états de défaut d'un conducteur de protection (3), le dispositif d'identification (14) étant relié du côté entrée avec le conducteur de phase (1), le conducteur de neutre (2) et le conducteur de protection (3) et du côté sortie avec un étage de commutation (19) pour le contrôle d'un disjoncteur différentiel (21);
**caractérisé**
**en ce que** le disjoncteur différentiel (21) commute des contacts de commutation (25, 26, 27) qui sont prévus dans le conducteur de phase (1), le conducteur de neutre (2) et le conducteur de protection (3)
et que le disjoncteur différentiel (21) est connecté au transformateur d'intensité de totalisation (22),
le dispositif d'identification (14) identifiant comme un premier état de défaut le fait que le conducteur de protection (3) ne soit pas connecté ou soit interrompu, et comme un second état de défaut la présence d'une tension simple sur le conducteur de protection (3) par le biais d'une différence de potentiel entre le conducteur de protection (3) et un détecteur (17) touché par un opérateur, le détecteur (17) présentant une surface de détection en métal conducteur qui est mise au potentiel de terre par le contact avec l'opérateur.

2. Dispositif de protection contre les courants de défaut selon la revendication 1,
**caractérisé**
**en ce qu'**entre le conducteur de phase (1) et le conducteur de neutre (2), d'une part, et le dispositif d'identification (14) pour l'identification des états de défaut du conducteur de protection, d'autre part, sont connectées des impédances protectrices (5, 7, 12).

3. Dispositif de protection contre les courants de défaut selon la revendication 2,
**caractérisé**
**en ce que** le dispositif d'identification (14) est relié par une ligne (15) au conducteur de protection (3).

4. Dispositif de protection contre les courants de défaut selon l'une des revendications précédentes,
**caractérisé**
**en ce que** le dispositif d'identification (14) présente un étage de séparation de potentiel (32) ainsi qu'un dispositif de commutation (31) monté parallèlement à celui-ci.

5. Dispositif de protection contre les courants de défaut selon l'une des revendications précédentes,
**caractérisé**
**en ce qu'**un potentiel de référence est généré indépendamment de la connexion de l'appareil de protection par les résistances (5, 7, 12), le dispositif d'identification (14) et le détecteur (17).

6. Dispositif de protection contre les courants de défaut selon l'une des revendications précédentes,
**caractérisé**
**en ce que** l'étage de séparation de potentiel (32) est constitué par un coupleur optoélectronique, un coupleur triac, un optotransistor à effet de champ, un coupleur piézoélectrique ou un relais.

7. Dispositif de protection contre les courants de défaut selon l'une des revendications précédentes,
**caractérisé**
**en ce que** le dispositif de commutation (31) est un élément de commutation à semi-conducteur.

8. Dispositif de protection contre les courants de défaut selon l'une des revendications précédentes,
**caractérisé**
**en ce que** le détecteur (17) est connecté par une résistance protectrice (35) à une électrode de commande de l'élément de commutation à semi-conducteur (31).

9. Dispositif de protection contre les courants de défaut selon l'une des revendications précédentes,
**caractérisé**
**en ce que** l'étage de séparation de potentiel (32) est relié du côté sortie à l'étage de commutation (19) du disjoncteur différentiel (21).

10. Dispositif de protection contre les courants de défaut selon l'une des revendications précédentes,
**caractérisé**
**en ce que** l'étage de commutation (19) est constitué par un élément de commutation à semi-conducteur (43).

11. Dispositif de protection contre les courants de défaut selon une des revendications précédentes,
**caractérisé**
**en ce qu'**un condensateur de filtrage et d'amortissement (44) est connecté parallèlement à la base et à l'émetteur de l'élément de commutation à semi-conducteur (43) de l'étage de commutation (19).

12. Dispositif de protection contre les courants de défaut selon l'une des revendications précédentes,
**caractérisé**
**en ce qu'**un dispositif d'affichage pour l'affichage de la nature de l'état de défaut est connecté au dispositif d'identification (14).
